# EUROPEAN PATENT APPLICATION

(11) **EP 4 845 349 A1**
(43) Date of publication of application: **25.11.2026**
(21) Application number: 25839918.7
(22) Date of filing: 08.05.2025
(51) Int. Cl.: H10F 19/90

(54) **CELL STRING, CELL MODULE, AND PHOTOVOLTAIC SYSTEM**

(30) Priority: 15.07.2024 CN 202410946864
(71) Applicant: Zhejiang Aiko Solar Energy Technology Co., Ltd., Yiwu, Jinhua Zhejiang 322000 (CN); Guangdong Aiko Solar Energy Technology Co., Ltd., Foshan, Guangdong 528000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN)
(72) Inventor: YANG, Xinqiang, Jinhua, Zhejiang 322000 (CN)
(74) Representative: EP&C
(86) International application number: PCT/CN2025/093554
(87) International publication number: WO 2026/016597

(57) **Abstract**

The present application relates to the field of solar cell technology, and provides a cell string, a cell assembly, and a photovoltaic system. The cell string includes a plurality of solder ribbons and a plurality of sliced cells, where the solder ribbon connects two adjacent sliced cells, and the sliced cell is formed by cutting an entire solar cell; the sliced cell includes two first sides and two second sides, a length of the first side is greater than a length of the second side, and the two first sides correspond to a first edge region and a second edge region, respectively; and a resistivity of at least one of a silicon substrate in the first edge region and a silicon substrate in the second edge region is greater than or equal to 30 Ω·cm. According to the cell string in some embodiments of the present application, since a resistivity of a silicon substrate in an edge region corresponding to at least one long side of sliced cells forming a cell string is greater than or equal to 30 Ω·cm, the edge recombination of the sliced cells is reduced, and the power generation efficiency of a cell assembly formed by the cell string is improved.

## Description

### Cross-Reference to Related Application

The present application claims the priority to Chinese Patent Application No. 202410946864.6, filed with the China National Intellectual Property Administration on July 15, 2024 and entitled "Cell String, Cell Assembly, and Photovoltaic System", which is incorporated herein by reference in its entirety.

### Technical Field

The present application relates to the field of solar cell technology, in particular to a cell string, a cell assembly, and a photovoltaic system.

### Background

A solar cell is capable of converting sunlight into electrical energy. Generally, an entire solar cell is cut to form sliced cells, and a plurality of sliced cells are connected to form a cell string using solder ribbons. However, edge recombination of the sliced cells is relatively large, leading to relatively low photoelectric conversion efficiency of the sliced cells, thereby resulting in relatively low power generation efficiency of a cell string formed by the cell string. Based on this, how to improve the power generation efficiency of the cell assembly formed by the cell string has become an urgent problem to be resolved.

### Summary

The present application provides a cell string, a cell assembly, and a photovoltaic system, which aim to solve the technical problem of how to improve power generation efficiency of a cell assembly formed by a cell string in the prior art.

The present application is implemented as follows. In an embodiment, a cell string includes a plurality of solder ribbons and a plurality of sliced cells, where the solder ribbon connects two adjacent sliced cells, and the sliced cell is formed by cutting an entire solar cell; the sliced cell includes two first sides and two second sides, a length of the first side is greater than a length of the second side, and the two first sides correspond to a first edge region and a second edge region, respectively; and
a resistivity of at least one of a silicon substrate in the first edge region and a silicon substrate in the second edge region is greater than or equal to 30 Ω·cm.

The present application further provides a cell assembly including any one of the cell strings.

The present application further provides a photovoltaic system including the cell assembly.

According to the cell string, the cell assembly, and the photovoltaic system in embodiments of the present application, since the resistivity of the silicon substrate in the edge region corresponding to at least one long side of sliced cells forming the cell string is greater than or equal to 30 Ω·cm, the edge recombination of the sliced cells is reduced, and the power generation efficiency of the cell assembly formed by the cell string is improved.

A part of the additional aspects and advantages of the present application will be provided in the following, and some will become apparent or can be learned through the practice of the present application.

### Brief Description of the Drawings

FIG. 1 is a schematic diagram of a structure of a cell string according to an embodiment of the present application.
FIG. 2 is a schematic diagram of a structure of a cell string according to an embodiment of the present application.

Description of reference numerals:
1000. cell string, 100. sliced cell, 11. first side, 111. first edge region, 112. second edge region, 12. second side, and 13. middle region.

### Detailed Description of Embodiments

To make the object, technical solutions, and advantages of the present application clearer, the present application will be further described in detail with reference to the accompanying drawings and embodiments. The examples of embodiments are shown in the accompanying drawings, where the same or similar labels throughout represent the same or similar elements or the elements with the same or similar functions. The embodiments described below with reference to the accompanying drawings are exemplary, and are only intended to explain the present application and cannot be understood as limiting the present application. In addition, it should be understood that the specific embodiments described here are intended for illustrating rather than limiting the present application.

In the description of the present application, it should be understood that, the terms "above", "below", "back", and "front" indicate the orientation or position relationship based on the orientation or position relationship shown in the accompanying drawings, only for the convenience of simple description of the present application, rather than indicating or implying that the devices or elements referred to must have a specific orientation, be constructed and operated in a specific orientation, and therefore cannot be understood as a limitation on the present application.

In the present application, unless otherwise specified and limited, the first feature "above" or "below" the second feature may include direct contact between the first and second features, or direct contact between the first and second features through additional features between them. Moreover, the first feature "over", "above", and "on" the second feature includes the first feature being directly above and diagonally above the second feature, or simply indicates that the first feature is horizontally higher than the second feature. The first feature "below", "beneath", and "under" the second feature includes the first feature directly below and diagonally below the second feature, or simply indicates that the horizontal height of the first feature is less than that of the second feature.

The following disclosure provides many different embodiments, or examples, to implement different features in the present application. The components and arrangements of specific examples are described below to simplify the disclosure of the present application. These are, of course, merely examples and are not intended to limit the present application. In addition, the present application may repeat reference numerals and/or letters in the various examples. This repetition is for the purpose of simplicity and clarity and does not in itself dictate a relationship between the various embodiments and/or configurations discussed. In addition, the present application provides examples of various specific processes and materials, but those of ordinary skill in the art can be aware of the present application of other processes and/or the usage scenarios of other materials.

According to the present application, since a resistivity of a silicon substrate in an edge region corresponding to at least one long side of sliced cells forming a cell string is greater than or equal to 30 Ω·cm, the edge recombination of the sliced cells is reduced, and the power generation efficiency of a cell assembly formed by the cell string is improved.

### Embodiment 1

A cell string 1000 in an embodiment of the present application includes a plurality of solder ribbons and a plurality of sliced cells 100, where the solder ribbon connects two adjacent sliced cells 100, and the sliced cell 100 is formed by cutting an entire solar cell; the sliced cell 100 includes two first sides 11 and two second sides 12, a length of the first side 11 is greater than a length of the second side 12, the two first sides 11 correspond to a first edge region 111 and a second edge region 112, respectively, where the first edge region 111 is a partial region of the sliced cell 100 having the first side 11, and the second edge region 112 is a partial region of the sliced cell 100 having the second side 12; and
a resistivity of at least one of a silicon substrate in the first edge region 111 and a silicon substrate in the second edge region 112 is greater than or equal to 30 Ω·cm, that is: a resistivity of the silicon substrate in the first edge region 111 is greater than or equal to 30 Ω·cm, or a resistivity of the silicon substrate in the second edge region 112 is greater than or equal to 30 Ω·cm, or resistivities of the silicon substrate in the first edge region 111 and the silicon substrate in the second edge region 112 are greater than or equal to 30 Ω·cm.

According to the cell string 1000 in some embodiments of the present application, since the resistivity of the silicon substrate in the edge region corresponding to at least one long side of sliced cells 100 forming the cell string 1000 is greater than or equal to 30 Ω·cm, the edge recombination of the sliced cells 100 is reduced, and the power generation efficiency of the cell assembly formed by the cell string 1000 is improved.

Specifically, one, two, three, four, or other numbers of solder ribbons may be provided. For a clearer illustration of a structure of the sliced cell 100, the solder ribbons are not shown in the accompanying drawings.

Specifically, the sliced cell 100 may be formed by cutting an entire solar cell into two, three, four, or other portions. No specific cutting proportion of the entire solar cell to form the sliced cell 100 is limited herein. For explanation and illustration, the sliced cell 100 is exemplified as a half-cut cell.

Specifically, in a case where the sliced cell 100 is formed by cutting an entire solar cell into two, four, or other even-numbered portions, the cutting line passes through a center point of the entire solar cell and is parallel to a side of the entire solar cell. In a case where the sliced cell 100 is formed by cutting an entire solar cell into three, five, or other odd-numbered portions, the cutting line is axially symmetric, and a symmetry axis passes through a center point of the entire solar cell and is parallel to a side of the entire solar cell.

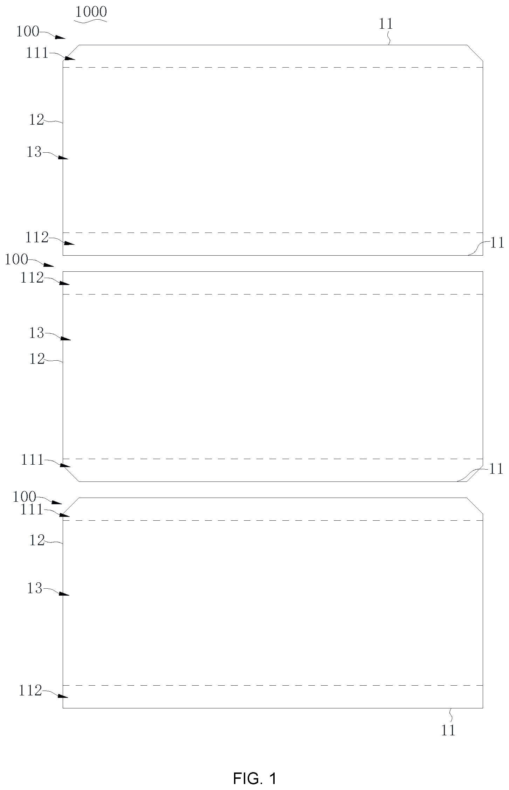

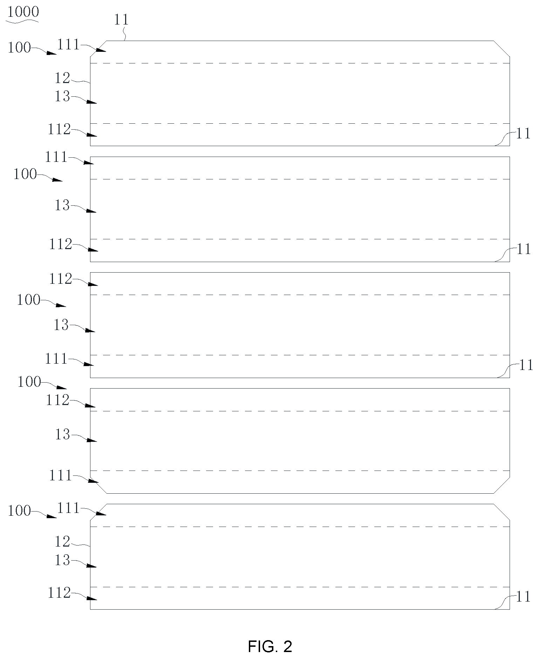

Specifically, one, two, three, four, or other numbers of sliced cells 100 in the cell string 1000 may be provided. In the example of FIG. 1, three sliced cells 100 are provided. In the example of FIG. 2, five sliced cells 100 are provided. These are only examples and do not constitute a limitation on the number of sliced cells 100 in the cell string 1000.

Specifically, the entire solar cell may be a bifacial solar cell, an interdigitated back contact (IBC) cell, a heterojunction with intrinsic thin layer (HJT) cell, a passivated emitter and rear cell (PERC), a tunnel oxide passivated contact (TopCon) cell, or the like. The sliced cell 100 may be a bifacial solar cell, an IBC cell, an HJT cell, a PERC cell, a TopCon cell, or the like. This is not limited herein.

It can be understood that the entire solar cell is generally square. The four corners of the square entire solar cell may include chamfered corners, rounded corners, right-angled corners, or other types of corners. Therefore, the sliced cell 100 formed by cutting the entire solar cell is rectangular. For the rectangular sliced cell 100, lengths of two adjacent sides are necessarily different.

Specifically, the sliced cell 100 includes two first sides 11 and two second sides 12. The two first sides 11 are opposite to each other, the two second sides 12 are opposite to each other, and the first side 11 and the second side 12 are adjacent to each other. A length of the first side 11 is greater than a length of the second side 12, so the first side 11 is a long side of the rectangular sliced cell 100, and the second side 12 is a short side of the rectangular sliced cell 100. The two first sides 11 correspond to a first edge region 111 and a second edge region 112, respectively, so the first edge region 111 and the second edge region 112 are both edge regions corresponding to the long sides.

Specifically, a resistivity of a silicon substrate in the first edge region 111 is greater than or equal to 30 Ω·cm. For example, the resistivity may be 30 Ω·cm, 32 Ω·cm, 35 Ω·cm, 38 Ω·cm, 50 Ω·cm, 80 Ω·cm, or 100 Ω·cm. The specific numerical value of the resistivity of the silicon substrate in the first edge region 111 is not limited herein.

Specifically, a resistivity of a silicon substrate in the second edge region 112 is greater than or equal to 30 Ω·cm. For example, the resistivity may be 30 Ω·cm, 32 Ω·cm, 35 Ω·cm, 38 Ω·cm, 50 Ω·cm, 80 Ω·cm, or 100 Ω·cm. The specific numerical value of the resistivity of the silicon substrate in the second edge region 112 is not limited herein.

Specifically, a resistivity of a silicon substrate in the first edge region 111 may be the same as or different from a resistivity of a silicon substrate in the second edge region 112.

In this embodiment, a resistivity of the silicon substrate in the first edge region 111 is greater than or equal to 30 Ω·cm, and a resistivity of the silicon substrate in the second edge region 112 is greater than or equal to 30 Ω·cm. In this way, the edge recombination of the sliced cell 100 can be further reduced, thereby further improving the power generation efficiency of the cell assembly formed by the cell string 1000.

It can be understood that, in other embodiments, a resistivity of the silicon substrate in the first edge region 111 may be greater than or equal to 30 Ω·cm, and a resistivity of the silicon substrate in the second edge region 112 may be less than 30 Ω·cm; or a resistivity of the silicon substrate in the first edge region 111 may be less than 30 Ω·cm, and a resistivity of the silicon substrate in the second edge region 112 may be greater than or equal to 30 Ω·cm.

It can be understood that, as long as a resistivity of the silicon substrate in at least one of the first edge region 111 and the second edge region 112 is greater than or equal to 30 Ω·cm, the edge recombination of the sliced cell 100 can be reduced, and the power generation efficiency of the cell assembly formed by the cell string 1000 can be improved. If resistivities of the silicon substrates in both the first edge region 111 and the second edge region 112 are greater than or equal to 30 Ω·cm, a reduction of edge recombination and an improvement of power generation efficiency of the cell assembly can be further enhanced.

Specifically, the sliced cell 100 includes a silicon substrate. In the present application, the silicon substrate is a monocrystalline silicon substrate. It can be understood that, in other embodiments, the silicon substrate may also be a polycrystalline silicon substrate. This is not limited herein.

It should be noted that, it should be noted that, the "resistivity" as used herein refers to an average resistivity of the silicon substrate in the corresponding region.

In this embodiment, the silicon substrate is square, and four corners of the silicon substrate are chamfered. It can be understood that, in other embodiments, the silicon substrate may be rectangular, circular, elliptical, triangular, or other shapes; corners of the silicon substrate may be rounded, pointed, or of other forms; and a plurality of corners of the silicon substrate may have the same form or different forms.

Specifically, the first edge region 111 and the second edge region 112 refer to spatial regions extending from one of the two first sides 11 to the other of the two first sides 11. From a thickness direction of the silicon substrate, the first edge region 111 extends inward from the first side 11, as shown in FIGS. 1 and 2. That is, the first edge region 111 is not formed only on a surface of the silicon substrate, but is a spatial region with a thickness.

Specifically, the thickness of the silicon substrate may be 30 µm to 300 µm. For example, the thickness may be 30 µm, 40 µm, 50 µm, 60 µm, 70 µm, 80 µm, 90 µm, 100 µm, 150 µm, 200 µm, 250 µm, or 300 µm. In this way, the thickness of the silicon substrate can be prevented from being too small, which would result in a too low concentration of photogenerated carriers, and can also be prevented from being too large, which would result in excessively high cost of the cell.

Specifically, the silicon substrate in the entire first edge region 111 may exhibit N-type conductivity or P-type conductivity. Alternatively, the silicon substrate in a portion of the first edge region 111 may exhibit N-type conductivity, and the silicon substrate in another portion of the first edge region 111 may exhibit P-type conductivity.

Similarly, the silicon substrate in the entire second edge region 112 may exhibit N-type conductivity or P-type conductivity. Alternatively, the silicon substrate in a portion of the second edge region 112 may exhibit N-type conductivity, and the silicon substrate in another portion of the second edge region 112 may exhibit P-type conductivity.

Specifically, N-type conductivity of a region indicates that the region exhibits N-type conductivity. This does not limit a type of dopant in the region. Further, in some embodiments, the region may not include P-type dopant elements and may include N-type dopant elements, such that the region exhibits N-type conductivity. In other embodiments, the region may also include both P-type dopant elements and N-type dopant elements, and a concentration of the N-type dopant elements is greater than a concentration of the P-type dopant elements, such that the region exhibits N-type conductivity.

Specifically, P-type conductivity of a region indicates that the region exhibits P-type conductivity. This does not limit a type of dopant in the region. Further, in some embodiments, the region may not include N-type dopant elements and may include P-type dopant elements, such that the region exhibits P-type conductivity. In other embodiments, the region may also include both P-type dopant elements and N-type dopant elements, and a concentration of the P-type dopant elements is greater than a concentration of the N-type dopant elements, such that the region exhibits P-type conductivity.

In some embodiments, the N-type dopant elements include at least one element selected from Group V elements and Group VI elements. Specifically, the Group V elements include nitrogen, phosphorus, arsenic, antimony, and bismuth. Specifically, the Group VI elements include oxygen, sulfur, selenium, tellurium, and polonium. That is, the N-type dopant elements include at least one element selected from nitrogen, phosphorus, arsenic, antimony, bismuth, oxygen, sulfur, selenium, tellurium, and polonium. In this way, a variety of N-type dopant elements are provided, such that the N-type dopant elements are more flexible and can adapt to more practical production scenarios.

In some embodiments, the P-type dopant elements include at least one element selected from Group III elements. Specifically, the Group III elements include boron, aluminum, gallium, indium, and thallium. That is, the P-type dopant elements include at least one element selected from boron, aluminum, gallium, indium, and thallium. In this way, a variety of P-type dopant elements are provided, such that the P-type dopant elements are more flexible and can adapt to more practical production scenarios.

In some embodiments, a concentration of acceptor dopants in the first edge region 111 is less than a concentration of acceptor dopants in the second edge region 112.

In this way, the recombination caused by copper contamination can be further reduced, which is beneficial for improving the photoelectric conversion efficiency of the sliced cell 100 made based on the silicon substrate.

Specifically, the acceptor dopants refer to P-type dopant elements. Donor dopants refer to N-type dopant elements.

It can be understood that, since a concentration of acceptor dopants in the first edge region 111 is less than a concentration of acceptor dopants in the second edge region 112, the amount of P-type dopant elements, such as Group III elements, in the first edge region 111 is reduced, thereby reducing recombination pairs formed between the Group III elements and oxygen as well as recombination caused by the dopant elements in the first edge region 111, and thus improving conversion efficiency.

It can be understood that, since a concentration of acceptor dopants in the second edge region 112 is less than a concentration of donor dopants in the second edge region 112, the second edge region 112 exhibits N-type conductivity.

In some embodiments, a concentration of donor dopants in the first edge region 111 is less than a concentration of donor dopants in the second edge region 112, and a concentration of donor dopants in the first edge region 111 is less than a concentration of acceptor dopants in the first edge region 111.

In this way, the first edge region 111 and the second edge region 112 in the silicon substrate are ensured to exhibit P-type conductivity and N-type conductivity, respectively.

In some embodiments, the sliced cell 100 is a half-cut cell, and a ratio of the concentration of acceptor dopant of the second edge region 112 to the concentration of acceptor dopant of the first edge region 111 is 1.01-10. For example, the ratio is 1.01, 1.02, 1.05, 1.1, 1.5, 1.8, 2, 3, 5, 8, 9, or 10.

In this way, the ratio of the concentration of acceptor dopant of the second edge region 112 to the concentration of acceptor dopant of the first edge region 111 is maintained within a suitable range greater than 1, which can avoid a relatively flat crystallization interface, a slow pulling rate, and low yield caused by the too small ratio, and can also avoid a crystallization interface concave toward the melt, large thermal stress, and easy breakage into polycrystalline caused by the too large ratio.

In some embodiments, the sliced cell 100 is a half-cut cell, and a concentration of acceptor dopant of the first edge region 111 is less than or equal to 10¹⁵ atoms/cm³. For example, the concentration is 1×10¹⁵ atoms/cm³, 0.8×10¹⁵ atoms/cm³, 0.5×10 ¹⁵ atoms/cm³, 0.1×10¹⁵ atoms/cm³, or the like.

In this way, the concentration of acceptor dopant of the first edge region 111 is maintained within a suitable range, which can avoid excessive recombination pairs formed by the acceptor dopant and oxygen and excessive recombination caused by the dopant elements due to an excessively high concentration of acceptor dopant in the first edge region 111, thereby facilitating an improvement of the conversion efficiency.

Specifically, two surfaces of the silicon substrate in a thickness direction are defined as a first surface and a second surface. The first surface can be a light-receiving surface and the second surface a back surface. Alternatively, the first surface can be a back surface and the second surface a light-receiving surface. This is not limited herein.

Specifically, the sliced cell 100 may include a first doped layer. The first doped layer is disposed on the first surface of the silicon substrate. Specifically, "the first doped layer being disposed on the first surface of the silicon substrate" can refer to the first doped layer being formed by diffusion on the first surface, or the first doped layer being formed by deposition on the first surface. The specific form of disposing the first doped layer on the first surface of the silicon substrate is not limited herein.

In some embodiments, the first doped layer exhibits N-type conductivity, forming a high-low junction with a region of N-type conductivity and forming a PN junction with a region of P-type conductivity.

In some embodiments, the first doped layer exhibits P-type conductivity, forming a PN junction with a region of N-type conductivity and forming a high-low junction with a region of P-type conductivity.

Specifically, the sliced cell 100 may further include a first passivation and antireflection layer and a first electrode. The first passivation and antireflection layer is stacked on the first doped layer. The first electrode penetrates the first passivation and antireflection layer to electrically connect the first doped layer. The first passivation and antireflection layer includes at least one of an aluminum oxide layer, a silicon nitride layer, a silicon oxide layer, and a silicon oxynitride layer. The first electrode includes at least one of a copper electrode, an aluminum electrode, and a silver electrode.

Specifically, the sliced cell 100 may further include a second passivation and antireflection layer and a second electrode. The second passivation and antireflection layer is disposed on the second surface of the silicon substrate. The second electrode penetrates the second passivation and antireflection layer to electrically connect the silicon substrate. The second passivation and antireflection layer includes at least one of an aluminum oxide layer, a silicon nitride layer, a silicon oxide layer, and a silicon oxynitride layer. The second electrode includes at least one of a copper electrode, an aluminum electrode, and a silver electrode.

In some embodiments, the first doped layer is a diffusion-doped layer.

In this way, a diffusion process can be used to introduce dopants into the silicon substrate, thereby forming the first doped layer in the silicon substrate, which facilitates achieving a high concentration in the first doped layer, a deep junction depth with the silicon substrate, and minimal surface damage.

It can be understood that, in other embodiments, the first doped layer may alternatively be an ion-implanted doped layer. In this way, the number of dopant atoms and the doping depth can be better controlled, lateral diffusion effects are reduced, and the required temperature is lower.

In some embodiments, the first doped layer is a doped polycrystalline silicon layer or a doped amorphous silicon layer, and a first passivation layer is disposed between the first doped layer and the silicon substrate. The first passivation layer is an intrinsic amorphous silicon layer or a silicon oxide layer.

In this way, the first passivation layer and the first doped layer stacked on the silicon substrate form a passivated contact structure, providing a passivation effect for the sliced cell 100. The first passivation layer allows majority carriers to tunnel into the first doped layer while blocking minority carrier recombination, thereby enabling lateral transport of majority carriers in the first doped layer and collection by the metal electrodes of the sliced cell 100, which can reduce recombination in the metal contact region and is conducive to improving the open-circuit voltage and short-circuit current of the sliced cell 100.

In one example, the first doped layer is a doped polycrystalline silicon layer, and an intrinsic amorphous silicon layer is disposed between the first doped layer and the silicon substrate. In another example, the first doped layer is a doped polycrystalline silicon layer, and a silicon oxide layer is disposed between the first doped layer and the silicon substrate. In yet another example, the first doped layer is a doped amorphous silicon layer, and an intrinsic amorphous silicon layer is disposed between the first doped layer and the silicon substrate. In still another example, the first doped layer is a doped amorphous silicon layer, and a silicon oxide layer is disposed between the first doped layer and the silicon substrate.

It can be understood that the first passivation layer forms a porous structure. The first doped layer penetrates the first passivation layer to form a high-low junction or a PN junction with the silicon substrate. The PN junction and the high-low junction formed between the first doped layer and the monocrystalline silicon substrate are all heterojunctions.

In some embodiments, the first doped layer is a doped polycrystalline silicon layer, and a first passivation layer is disposed between the first doped layer and the silicon substrate. The first passivation layer is an intrinsic amorphous silicon layer or a silicon oxide layer. The silicon substrate forms an internal diffusion layer. The internal diffusion layer forms a high-low junction with the doped polycrystalline silicon layer and forms a high-low junction or a PN junction with the silicon substrate.

In this way, a better passivation effect is provided for the sliced cell 100, which can further reduce recombination in the metal contact region and is conducive to further improving the open-circuit voltage and short-circuit current of the sliced cell 100.

It can be understood that, since the internal diffusion layer is formed by diffusion from the doped polycrystalline silicon layer through the first passivation layer into the silicon substrate, the internal diffusion layer has the same conductivity type as the doped polycrystalline silicon layer, and therefore, a high-low junction is formed between the internal diffusion layer and the doped polycrystalline silicon layer. When the internal diffusion layer exhibits N-type conductivity, the internal diffusion layer forms a high-low junction with a region of the silicon substrate exhibiting N-type conductivity and forms a PN junction with a region of the silicon substrate exhibiting P-type conductivity. When the internal diffusion layer exhibits P-type conductivity, the internal diffusion layer forms a PN junction with a region of the silicon substrate exhibiting N-type conductivity and forms a high-low junction with a region of the silicon substrate exhibiting P-type conductivity.

In some embodiments, the sliced cell 100 includes a second doped layer, and the second doped layer is disposed on the second surface of the silicon substrate. When the first doped layer exhibits N-type conductivity, the second doped layer exhibits P-type conductivity; or when the first doped layer exhibits P-type conductivity, the second doped layer exhibits N-type conductivity.

In this way, doped layers are formed on both the first surface and the second surface of the silicon substrate, thereby forming a PN junction or a high-low junction, so that both surfaces of the sliced cell 100 in the thickness direction can receive light to generate electricity, which is conducive to improving the photoelectric conversion efficiency of the sliced cell 100.

It should be noted that the explanations and descriptions regarding the second doped layer can refer to those regarding the first doped layer, and are not repeated herein to avoid redundancy.

In some embodiments, a passivation layer is formed on a cut surface of the sliced cell 100.

In this way, recombination at the cut surface can be reduced, improving the photoelectric conversion efficiency and thereby enhancing the power generation efficiency of the cell assembly formed by the cell string 1000.

Specifically, the passivation layer includes at least one of aluminum oxide, silicon nitride, silicon oxynitride, and silicon oxide.

### Embodiment 2

In some embodiments, the first edge region 111 is farther from a center of the entire solar cell than the second edge region 112, and a resistivity of the silicon substrate in the first edge region 111 is greater than or equal to a resistivity of the silicon substrate in the second edge region 112.

In this way, the doping concentration of the first edge region 111 can be reduced, thereby decreasing recombination pairs formed by the dopant elements and oxygen as well as recombination caused by the dopant elements in the first edge region 111, which improves the conversion efficiency.

### Embodiment 3

In some embodiments, a resistivity of the silicon substrate in the first edge region 111 is greater than 100 Ω·cm. For example, the resistivity can be 100 Ω·cm, 120 Ω·cm, 150 Ω·cm, 200 Ω·cm, 400 Ω·cm, 500 Ω·cm, 502 Ω·cm, 550 Ω·cm, 600 Ω·cm, 700 Ω·cm, 800 Ω·cm, 900 Ω·cm, or the like.

In this way, the first edge region 111 has a high resistivity, so fewer dopant elements are present in the first edge region 111, thereby reducing the doping concentration and decreasing recombination pairs formed by the dopant elements and oxygen as well as recombination caused by the dopant elements. This can avoid excessive doping concentration and severe recombination caused by an excessively low resistivity of the silicon substrate in the first edge region 111.

### Embodiment 4

In some embodiments, a ratio of a resistivity of the silicon substrate in the first edge region 111 to a resistivity of the silicon substrate in the second edge region 112 is greater than or equal to 1.2. For example, the ratio can be 1.2, 1.5, 1.8, 2, 3, 4, 7, 8, or the like.

In this way, the resistivity of the first edge region 111 is much greater than the resistivity of the second edge region 112, which is conducive to reducing recombination and improving the conversion efficiency. It can be understood that a much higher resistivity of the first edge region 111 compared to the second edge region 112 indicates that the doping concentration in the first edge region 111 is lower than the doping concentration in the second edge region 112. Therefore, dopant elements in the first edge region 111 can be reduced, thereby decreasing recombination pairs formed by the dopant elements and oxygen as well as recombination caused by the dopant elements, which further improves the conversion efficiency.

### Embodiment 5

In some embodiments, the sliced cell 100 includes a middle region 13, and the middle region 13 is disposed between the first edge region 111 and the second edge region 112. A resistivity of a silicon substrate in the middle region 13 is less than or equal to a resistivity of the silicon substrate in the first edge region 111 and greater than or equal to a resistivity of the silicon substrate in the second edge region 112.

In this way, the resistivity of the silicon substrate in the sliced cell 100 gradually decreases from the edges toward the center of the entire solar cell, which is conducive to reducing recombination and improving the conversion efficiency.

### Embodiment 6

In some embodiments, a resistivity of the middle region 13 is greater than or equal to 50 Ω·cm. For example, the resistivity can be 50 Ω·cm, 51 Ω·cm, 55 Ω·cm, 60 Ω·cm, 80 Ω·cm, 100 Ω·cm, or 200 Ω·cm.

In this way, the resistivity of the middle region 13 is within a suitable range, which can further enhance the field-effect passivation in the sliced cell 100 and is conducive to further improving carrier transport. This can avoid poor field-effect passivation caused by an excessively low resistivity.

### Embodiment 7

In some embodiments, a length of the first edge region 111 is equal to a length of the first side 11, and a width of the first edge region 111 is 1/10 to 1/3 of a length of the second side 12. For example, the width of the first edge region 111 can be 0.1, 0.12, 0.15, 0.18, 0.2, 0.22, 0.25, 0.28, 0.3, or 0.33 times the length of the second side 12.

In this way, the width of the first edge region 111 is within a suitable range, so that the relative area of the first edge region 111 in the sliced cell 100 is within an appropriate range. This can avoid a relatively small area of the first edge region 111 and poor edge recombination suppression caused by an excessively small width of the first edge region 111, and can also avoid a relatively large area of the first edge region 111, excessively high overall resistivity of the silicon substrate in the sliced cell 100, and poor conductivity caused by an excessively large width of the first edge region 111.

### Embodiment 8

In some embodiments, a length of the second edge region 112 is equal to a length of the first side 11, and a width of the second edge region 112 is 1/10 to 1/3 of a length of the second side 12. For example, the width of the second edge region 112 can be 0.1, 0.12, 0.15, 0.18, 0.2, 0.22, 0.25, 0.28, 0.3, or 0.33 times the length of the second side 12.

In this way, the width of the second edge region 112 is within a suitable range, so that the relative area of the second edge region 112 in the sliced cell 100 is within an appropriate range. This can avoid a relatively small area of the second edge region 112 and poor edge recombination suppression caused by an excessively small width of the second edge region 112, and can also avoid a relatively large area of the second edge region 112, excessively high overall resistivity of the silicon substrate in the sliced cell 100, and poor conductivity caused by an excessively large width of the second edge region 112.

Specifically, the width of the first edge region 111 may be the same as or different from the width of the second edge region 112.

### Embodiment 9

In some embodiments, the cell string 1000 includes a plurality of cell groups, and each cell group includes a first chamfered cell, a non-chamfered cell, and a second chamfered cell arranged in sequence. A resistivity of a silicon substrate in the first chamfered cell is greater than a resistivity of a silicon substrate in the non-chamfered cell, and a resistivity of a silicon substrate in the second chamfered cell is greater than a resistivity of a silicon substrate in the non-chamfered cell.

In this way, since the average resistivity of the silicon substrates of the first chamfered cell and the second chamfered cell is greater than the average resistivity of the silicon substrate in the non-chamfered cell, carrier recombination can be reduced, thereby increasing the power generation current of the first chamfered cell and the second chamfered cell, which improves current matching between the chamfered cells and the non-chamfered cell.

It can be understood that the first chamfered cell and the second chamfered cell, both typically located at the edge portions of the entire solar cell, have a current less than a current of the non-chamfered cell located in the middle portion of the entire solar cell. When the first chamfered cell, the non-chamfered cell, and the second chamfered cell having different currents are connected in series to form the cell string 1000, current matching is required. The current matching is achieved by increasing the power generation current of the chamfered cells, so that the current of the cell string 1000 can be increased, thereby improving the power generation efficiency of the cell assembly formed by the cell string 1000.

Specifically, one, two, three, or other numbers of non-chamfered cells may be provided. This is not limited herein.

It can be understood that, since the four corners of the entire solar cell are typically chamfered, when the cell string 1000 is formed, the sequence of the sliced cells 100 is usually not adjusted. Therefore, the first chamfered cell, the non-chamfered cell, and the second chamfered cell are cut from the same entire solar cell.

It should be noted that the "resistivity" as used herein refers to an average resistivity of the silicon substrate in the corresponding region. That is, the average resistivity of the silicon substrate in the first chamfered cell is greater than the average resistivity of the silicon substrate in the non-chamfered cell, and the average resistivity of the silicon substrate in the second chamfered cell is greater than the average resistivity of the silicon substrate in the non-chamfered cell.

Specifically, the average resistivity refers to the average value of resistivities measured at points randomly selected in the silicon substrate in the sliced cell 100 along the same direction at fixed intervals.

Further, the direction along which the points are selected can be any direction. Preferably, the direction along which the points are selected is parallel to the first side 11.

Further, a spacing between adjacent test points is 2 mm to 10 mm. For example, the spacing can be 2 mm, 3 mm, 4 mm, 5 mm, 6 mm, 7 mm, 8 mm, 9 mm, or 10 mm. In this way, the spacing between adjacent test points is within a suitable range, which can avoid insignificant differences and data lacking significance caused by excessively small spacing, and can also avoid overly large differences and an average value insufficiently representative of the average resistivity caused by excessively large spacing.

Further, the number of test points is 5 to 20. For example, the number of test points can be 5, 8, 10, 12, 15, 18, or 20. In this way, the number of test points is within a suitable range, which can avoid an average value insufficiently representative of the average resistivity caused by an excessively small number, and can also avoid excessive testing and calculation caused by an excessively large number, thereby reducing efficiency.

In this embodiment, the spacing between adjacent test points is 5 mm, and the number of test points is 10.

### Embodiment 10

A cell assembly according to an embodiment of the present application includes the cell string 1000 according to any one of Embodiments 1 to 9.

According to the cell assembly in some embodiments of the present application, since the resistivity of the silicon substrate in the edge region corresponding to at least one long side of sliced cells 100 forming the cell string 1000 is greater than or equal to 30 Ω·cm, the edge recombination of the sliced cells 100 is reduced, and the power generation efficiency of the cell assembly formed by the cell string 1000 is improved.

In this embodiment, the cell assembly can further include a metal frame, a backsheet, photovoltaic glass, and an encapsulant. The encapsulant may be filled between the front and back surfaces of the solar cells, the photovoltaic glass, adjacent cells, and the like, serving as a filler. The encapsulant can be a transparent polymer with good light transmittance and aging resistance. For example, the encapsulant can be an EVA film or a POE film. The specific selection can be made according to actual conditions, and is not limited herein.

The photovoltaic glass can cover the encapsulant on the front surface of the solar cells. The photovoltaic glass can be ultra-clear glass, which has high light transmittance, high transparency, and superior physical, mechanical, and optical properties. For example, the transmittance of ultra-clear glass can reach 92% or more, allowing the solar cells to be protected without significantly affecting the efficiency of the solar cells. Meanwhile, the encapsulant can bond the photovoltaic glass and the solar cells together. The presence of the encapsulant can provide sealing, insulation, and protection against water and moisture for the solar cells.

The backsheet can be attached to the encapsulant on the back surface of the solar cells. The backsheet can provide protection and support for the solar cells, exhibiting reliable insulation, water resistance, and aging resistance. The backsheet can typically be selected from tempered glass, organic glass, aluminum alloy TPT composite films, or the like. The specific selection can be made according to actual conditions, and is not limited herein. The assembly of the backsheet, the solar cells, the encapsulant, and the photovoltaic glass can be disposed on a metal frame. The metal frame serves as the main external support structure of the cell assembly, providing stable support and installation. For example, the cell assembly can be installed at a desired location via the metal frame.

### Embodiment 11

A photovoltaic system according to an embodiment of the present application includes the cell assembly according to Embodiment 10.

According to the photovoltaic system in some embodiments of the present application, since the resistivity of the silicon substrate in the edge region corresponding to at least one long side of sliced cells 100 forming the cell string 1000 is greater than or equal to 30 Ω·cm, the edge recombination of the sliced cells 100 is reduced, and the power generation efficiency of the cell assembly formed by the cell string 1000 is improved.

In this embodiment, the photovoltaic system can be applied in photovoltaic power stations, such as ground-mounted power stations, rooftop power stations, and floating power stations, and can also be applied in devices or equipment utilizing solar energy for power generation, such as user solar power supplies, solar street lights, solar vehicles, and solar buildings. Of course, it can be understood that the application scenarios of the photovoltaic system are not limited to the foregoing. That is, the photovoltaic system can be applied in all fields requiring solar energy for power generation. Taking a photovoltaic power generation system grid as an example, the photovoltaic system can include a photovoltaic array, a combiner box, and an inverter. The photovoltaic array can be an array combination of a plurality of cell assemblies. For example, a plurality of cell assemblies can form a plurality of photovoltaic arrays. The photovoltaic arrays are connected to the combiner box, and the combiner box collects the currents generated by the photovoltaic arrays. The combined current then passes through the inverter to be converted into alternating current meeting the requirements of the utility grid, and is connected to the utility network to achieve the solar power supply.

Below, a cell assembly formed by a cell string 1000 of the related art is used as a comparative example, and is compared with the cell assembly formed by the cell string 10001000 of the present application. In one comparative example, the cell assembly of the related art has a photoelectric conversion efficiency of 24.2%. In one example of the present application, the cell assembly formed by the cell string 1000 of the present application has a photoelectric conversion efficiency of 24.5%. It is clear that the cell assembly formed by the cell string 1000 of the present application has a higher photoelectric conversion efficiency and higher power generation efficiency.

In the description of the specification, the reference terms "some embodiments", "illustrative embodiments", "examples", "specific examples", or "some examples" refer to the specific features, structures, materials, or characteristics described in conjunction with the embodiments or examples included in at least one embodiment or example of the present application. The schematic expressions of the above terms in the specification do not necessarily refer to the same embodiments or examples. Moreover, the specific features, structures, materials, or characteristics described can be combined in an appropriate manner in any one or more embodiments or examples.

In addition, the above are only preferred embodiments of the present application and are not intended to limit the present application. Any modifications, equivalent substitutions, and improvements made within the spirit and principles of the present application shall be included in the scope of protection of the present application.

## Claims

1. A cell string, comprising a plurality of solder ribbons and a plurality of sliced cells, wherein the solder ribbon connects two adjacent sliced cells, and the sliced cell is formed by cutting an entire solar cell; the sliced cell comprises two first sides and two second sides, a length of the first side is greater than a length of the second side, and the two first sides correspond to a first edge region and a second edge region, respectively; and
a resistivity of at least one of a silicon substrate in the first edge region and a silicon substrate in the second edge region is greater than or equal to 30 Ω·cm.

2. The cell string according to claim 1, wherein the first edge region is farther from a center of the entire solar cell than the second edge region, and a resistivity of the silicon substrate in the first edge region is greater than or equal to a resistivity of the silicon substrate in the second edge region.

3. The cell string according to claim 2, wherein the resistivity of the silicon substrate in the first edge region is greater than 100 Ω·cm.

4. The cell string according to claim 2, wherein a ratio of the resistivity of the silicon substrate in the first edge region to the resistivity of the silicon substrate in the second edge region is greater than or equal to 1.2.

5. The cell string according to claim 2, wherein the sliced cell comprises a middle region, the middle region is disposed between the first edge region and the second edge region, and a resistivity of a silicon substrate in the middle region is less than or equal to the resistivity of the silicon substrate in the first edge region, and greater than or equal to the resistivity of the silicon substrate in the second edge region.

6. The cell string according to claim 5, wherein a resistivity of the middle region is greater than or equal to 50 Ω·cm.

7. The cell string according to claim 1, wherein a length of the first edge region is equal to a length of the first side, and a width of the first edge region is 1/10 to 1/3 of a length of the second side.

8. The cell string according to claim 1, wherein a length of the second edge region is equal to a length of the first side, and a width of the second edge region is 1/10 to 1/3 of a length of the second side.

9. The cell string according to claim 1, wherein the cell string comprises a plurality of cell groups, and each cell group comprises a first chamfered cell, a non-chamfered cell, and a second chamfered cell arranged in sequence; a resistivity of a silicon substrate in the first chamfered cell is greater than a resistivity of a silicon substrate in the non-chamfered cell, and a resistivity of a silicon substrate in the second chamfered cell is greater than the resistivity of the silicon substrate in the non-chamfered cell.

10. A cell assembly, comprising the cell string according to any one of claims 1-9.

11. A photovoltaic system, comprising the cell assembly according to claim 10.
